(19) Europäisches Patentamt
European Patent Office
Office européen des brevets

(11) **EP 1 786 025 B1**

(12) **FASCICULE DE BREVET EUROPEEN**

(45) Date de publication et mention
de la délivrance du brevet:
**08.12.2010 Bulletin 2010/49**

(51) Int Cl.:
*H01L 21/20* (2006.01)    *C30B 33/00* (2006.01)

(21) Numéro de dépôt: **06123069.4**

(22) Date de dépôt: **27.10.2006**

(54) **Procédé de formation de couches non-contraintes**

Verfahren zur Herstellung von relaxierten Schichten

Process for forming relaxed layers

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **28.10.2005 FR 0511040**

(43) Date de publication de la demande:
**16.05.2007 Bulletin 2007/20**

(73) Titulaire: **S.O.I.Tec Silicon on Insulator Technologies
38190 Bernin (FR)**

(72) Inventeurs:
• **Daval, Nicolas
38000 GRENOBLE (FR)**
• **Chahra, Zohra
38240 MEYLAN (FR)**
• **Larderet, Romain
38240 MEYLAN (FR)**

(74) Mandataire: **Le Forestier, Eric et al
Cabinet Régimbeau
20, rue de Chazelles
75847 Paris Cedex 17 (FR)**

(56) Documents cités:
**WO-A-01/99169        WO-A-02/15244
WO-A-02/27783        WO-A-2004/006326
WO-A-2004/006327     US-A1- 2003 139 000**

• **PATENT ABSTRACTS OF JAPAN vol. 2003, no. 12, 5 décembre 2003 (2003-12-05) & JP 2004 189505 A (UNIV TOHOKU), 8 juillet 2004 (2004-07-08)**

**Description**

L'invention concerne la formation d'une couche en matériau cristallin non contraint et destinée à des applications dans l'électronique, l'optique ou l'optronique, et plus particulièrement la réalisation d'une structure comprenant une telle couche.

On dit ici qu'une couche est « contrainte » lorsque sa structure cristalline est élastiquement contrainte en tension ou en compression si bien que son paramètre de maille est sensiblement différent du paramètre de maille nominal du matériau la constituant, le paramètre de maille nominal d'un matériau étant son paramètre de maille lorsqu'il est sous sa forme massive et à l'état monocristallin.

A l'inverse, on dit qu'une couche est « totalement relâchée » ou « non contrainte » si le matériau cristallin qui la constitue a un paramètre de maille sensiblement identique à son paramètre de maille nominal.

Une couche non contrainte a donc une structure cristallographique stable lorsqu'elle est soumise à des contraintes externes, telles que des contraintes thermiques.

Il est possible de trouver de telles couches non contraintes directement dans des plaques en matériau massif. Cependant, la fabrication de matériau massif est limitée à un petit nombre de matériaux, tels que le silicium, l'AsGa, le germanium, le saphir ou autre.

Pour réaliser des couches non contraintes constituées d'autres types de matériaux, il est connu de former dans une même plaque une telle couche sur un substrat massif constitué d'un autre matériau cristallin, en intercalant une couche tampon entre le substrat et la couche.

Dans cette configuration, une « couche tampon » s'entend comme une couche de transition adaptant le paramètre de maille de la couche formée avec celui du substrat. Une telle couche tampon peut avoir ainsi une composition variant graduellement en épaisseur, la variation graduelle de composants de la couche tampon étant alors directement associée à une variation graduelle de son paramètre de maille entre les paramètres de maille respectifs du substrat et de la couche formée.

On peut par exemple citer la formation d'une couche en SiGe à partir d'un substrat massif de silicium par l'intermédiaire d'une couche tampon en SiGe ayant sa composition en germanium augmentant progressivement entre le substrat et la couche de SiGe.

Le principe de « la couche tampon » permet ainsi de réaliser des couches non contraintes constituées de matériaux n'existant pas ou peu sous forme massive.

D'autre part, il peut être intéressant d'intégrer ces couches non contraintes dans des structures semiconducteur-sur-isolant, une structure semiconducteur-sur-isolant comprenant alors la couche non contrainte sur un matériau électriquement isolant, ce matériau isolant étant compris dans un substrat massif (tel que par exemple un substrat en verre) ou constituant une couche épaisse (telle qu'une couche de $SiO_2$ ou de $Si_3N_4$) intercalée entre la couche non contrainte et un substrat massif sous-jacent. De telles structures semiconducteur-sur-isolant présentent notamment de meilleures propriétés électriques et/ou optiques par rapport à des structures massives, améliorant ainsi les performances des composants réalisés dans la couche non contrainte.

Une structure semiconducteur-sur-isolant est typiquement réalisée par transfert de couche d'une plaque donneuse sur une plaque réceptrice, la plaque donneuse pouvant être massive, ou composite telle qu'une plaque comprenant une couche tampon et une couche non contrainte sus-épitaxiée.

De telles techniques de transfert de couche comprennent une étape de collage de plaque (encore appelée « Wafer Bonding »), la plaque donneuse étant collée avec la plaque réceptrice, puis une étape de retrait d'une partie de la plaque donneuse pour n'en laisser sur la plaque réceptrice que ladite couche transférée.

La réduction de la plaque donneuse peut se faire par exemple par attaque mécano-chimique de la partie arrière (au moyen par exemple de polissage, meulage, planarisation mécano-chimique, gravure chimique, gravure chimique sélective...) selon des techniques appelées « polish-back » et/ou « etch-back », ou par exemple par découpe de la plaque donneuse, après implantation atomique au niveau de la zone où on souhaite découper, selon une technique appelée Smart Cut® connue de l'homme du métier (on pourra par exemple se référer à l'ouvrage intitulé « Silicon-on-insulator technology: materials to VLSI, 2nd Edtion » de Jean-Pierre Colinge, chez Kluwer Academic Publishers, p. 50 et 51).

Une technique de transfert d'une couche de SiGe non contrainte à partir d'une plaque donneuse composite comportant une couche tampon, selon la technique etch-back est notamment décrite dans le document WO 01/99169.

Néanmoins, cette technique de transfert de couche non contrainte est longue, coûteuse et entraîne la perte de la plaque donneuse après transfert.

Dans le document US 2003/013900, est décrit un procédé permettant la formation de couches minces, de SiGe non contraintes sur isolateur grâce à un processus d'interdiffusion lors d'un traitement thermique.

Dans le document WO 02/27783, est décrite une technique permettant de transférer une couche de SiGe non contraint par Smart Cut®. Cette technique permet de récupérer la partie retirée de la plaque donneuse, pour éventuellement la recycler.

Cependant, un tel transfert de la couche peut ne pas assurer une parfaite homogénéité en épaisseur de celle-ci, et une étape additionnelle de polissage doit alors être mise en oeuvre afin d'augmenter l'homogénéité à courte distance. Cependant, un tel polissage diminue l'homogénéité à longue distance (c'est-à-dire une homogénéité mesurée entre le centre et les bords de la plaque).

Dans les documents WO 02/15244 et WO 04/06327, est décrite une méthode de transfert d'une couche de SiGe non contraint, à partir d'une plaque donneuse incluant une couche de Si contraint entre la couche tampon et la couche de SiGe non contraint. La méthode consiste à transférer la couche de SiGe non contraint et la couche de Si contraint sur une plaque réceptrice, puis à enlever sélectivement le Si contraint vis-à-vis du SiGe non contraint. Ainsi, on peut obtenir une couche finale de SiGe non contraint présentant une homogénéité à courte et longue distance, en utilisant la technique Smart Cut®, et sans mettre en oeuvre un polissage final.

Cependant, lors du transfert de la couche de Si contraint, des traitements thermiques sont appliqués, et peuvent entraîner une diffusion de germanium dans la couche de Si contraint, diminuant alors la sélectivité, entre le Si contraint et le SiGe non contraint, nécessaire à la gravure chimique finale. Etant donné la faible épaisseur d'une couche de Si contraint, cette perte de sélectivité entre la couche peut conduire à une attaque du SiGe non contraint, et donc à la diminution de la qualité de celle-ci et de son homogénéité en épaisseur à courte distance.

Un objectif principal de l'invention est d'éviter tous ces inconvénients, en proposant un procédé de formation d'une couche totalement relâchée ayant une bonne homogénéité en épaisseur.

Un autre but de l'invention est de réaliser une structure semiconducteur-sur-isolant ayant une couche en matériau cristallin non contraint et ayant une bonne homogénéité en épaisseur.

Pour atteindre ces objectifs, l'invention propose un procédé selon la revendication 1 comportant un procédé de formation d'une couche en matériau cristallin non contraint élastiquement et destinée à des applications dans l'électronique, l'optique, ou l'optronique, caractérisé en ce que le procédé est mis en oeuvre à partir d'une structure comprenant une première couche cristalline élastiquement contrainte en tension (ou respectivement en compression) et une deuxième couche cristalline élastiquement contrainte en compression (ou respectivement en tension), la deuxième couche étant adjacente à la première couche, en ce que le procédé comprend une étape de diffusion entre les deux couches de sorte que les différences entre les compositions respectives des deux couches se réduisent progressivement, jusqu'à être identiques l'une à l'autre, les deux couches ne formant alors plus qu'une seule couche finale en un matériau cristallin ayant une composition globalement uniforme, et en ce que les compositions, les épaisseurs et les taux de contraintes respectifs des deux couches sont initialement choisis de sorte que, après diffusion, le matériau constituant alors la couche finale ne présente globalement plus de contrainte élastique.

D'autres caractéristiques de ce procédé de formation de couche non contrainte sont les suivantes :

- les paramètres de maille des première et deuxième couches contraintes sont respectivement égaux au paramètre de maille nominal du matériau constituant la couche finale ;
- la deuxième couche est une couche épitaxiée sur la première couche ;
- les première et deuxième couches ont au moins un élément de leurs compositions respectives en commun ;
- la première couche est en $Si_{1-x}Ge_x$, la deuxième couche est en $Si_{1-y}Ge_y$ et la couche finale est en $Si_{1-z}Ge_z$, x et y étant respectivement compris entre 0 inclus et 1 inclus, x étant sensiblement différent de y, et :

$$z = ( x * th_1 + y * th_2 ) / ( th_1 + th_2 )$$

  $th_1$ étant l'épaisseur de la première couche;
  $th_2$ étant l'épaisseur de la deuxième couche;
  et les paramètres de maille respectifs des première et deuxième couches contraintes sont respectivement égaux au paramètre de maille nominal du $Si_{1-z}Ge_z$;
- ladite structure comprend en outre une couche en matériau amorphe située sous les deux couches cristallines ;
- la couche en matériau amorphe est électriquement isolante ;
- la couche en matériau amorphe comprend au moins un des matériaux suivants : $SiO_2$, $Si_3N_4$, $Si_xO_yN_z$;
- la diffusion est mise en oeuvre par traitement thermique.

Selon un deuxième aspect, l'invention propose un procédé selon la revendication 10 comportant un procédé de réalisation d'une structure comprenant une couche cristalline non contrainte élastiquement et destinée à des applications dans l'électronique, l'optique, ou l'optronique, caractérisé en ce qu'il comprend les étapes suivantes :

- croissance cristalline d'une deuxième couche cristalline sur une première couche cristalline élastiquement contrainte en tension (ou respectivement en compression), de sorte que la deuxième couche soit élastiquement contrainte en compression (ou respectivement en tension) par la première couche, et que l'épaisseur de la deuxième couche soit choisie de l'ordre d'une épaisseur de référence, l'épaisseur de référence correspondant à une épaisseur pour laquelle l'ensemble des éléments composant la deuxième couche et l'ensemble des éléments composant la première couche puissent former, une fois combinés ensemble, une couche uniforme globalement non contrainte ;

- diffusion d'éléments entre les deux couches de sorte que les différences entre les compositions respectives des deux couches se réduisent progressivement, jusqu'à être identiques l'une à l'autre, les deux couches ne formant alors plus qu'une seule couche finale en un matériau cristallin ayant une composition globalement uniforme et élastiquement non contrainte, réalisant au moins une partie de ladite structure.

D'autres caractéristiques de ce procédé de réalisation d'une structure comprenant une couche non contrainte sont les suivantes :

- le paramètre de maille de la première couche est choisi sensiblement égal au paramètre nominal du matériau composant la couche finale ;
- la croissance cristalline est en outre mise en oeuvre de sorte que la deuxième couche ait une épaisseur inférieure ou égale à une épaisseur critique au-delà de laquelle des contraintes élastiques se relâcheraient substantiellement ;
- en outre, antérieurement à l'étape de croissance cristalline, un collage de la première couche avec un substrat récepteur, ladite structure finalement réalisée comprenant donc ladite couche finale mais aussi ce substrat récepteur ;
- le collage est réalisé par l'intermédiaire d'une couche de collage formée sur l'une et/ou l'autre des faces à coller ;
- la couche de collage comprend au moins un des deux matériaux suivants : $SiO_2$, $Si_3N_4$;
- le collage est moléculaire et est ensuite renforcé par un traitement thermique adapté ;
- la première couche est comprise dans une plaque au moment du collage, et le procédé comprend en outre, entre les étapes de collage et de croissance cristalline, un retrait de la partie de la plaque ne comprenant pas la première couche ;
- le retrait de la partie de la plaque ne comprenant pas la première couche est mis en oeuvre par au moins une des techniques suivantes : meulage, CMP, CMP sélective, gravure chimique, gravure chimique sélective ;
- le procédé comprend, en outre, antérieurement au collage, une implantation d'espèces atomiques dans la plaque de sorte à y créer une zone de fragilisation à une profondeur sensiblement égale à l'épaisseur de la première couche ; et le retrait d'une partie de la plaque est obtenu en soumettant la zone de fragilisation à des contraintes aptes à rompre les liaisons fragiles et à détacher alors ladite première couche du reste de la plaque ;
- en outre, entre le retrait d'une partie de la plaque et la croissance cristalline, une étape de finition de la surface de la première couche pour préparer sa surface à la croissance cristalline de la deuxième couche ;
- la première couche est en $Si_{1-x}Ge_x$, la deuxième couche est en $Si_{1-y}Ge_y$, et la couche finale est en $Si_{1-z}Ge_z$, x et y étant respectivement compris entre 0 inclus et 1 inclus, x étant sensiblement différent de y, et :

$$z = ( x * th_1 + y * th_2 ) / ( th_1 + th_2 )$$

$th_1$ étant l'épaisseur de la première couche ;
$th_2$ étant l'épaisseur de la deuxième couche ;
et le paramètre de maille de la première couche contrainte est sensiblement égal au paramètre de maille nominal du $Si_{1-z}Ge_z$ ;
- la première couche est en Si contraint et est comprise dans un substrat silicium contraint-sur-isolant (« sSOI »).

D'autres caractéristiques, buts et avantages seront décrits dans la description non limitative qui suit de l'invention, illustrée par les figures suivantes :

Les figures 1A et 1C représentent différentes étapes d'un procédé pour réaliser une structure comprenant une couche non contrainte, selon l'invention.
Les figures 2A et 2B représentent respectivement une structure semiconducteur-sur-isolant avant et après diffusion selon l'invention.
Les figures 3A à 3E représentent différentes étapes d'un procédé pour réaliser une structure particulière comprenant une couche non contrainte, selon l'invention.

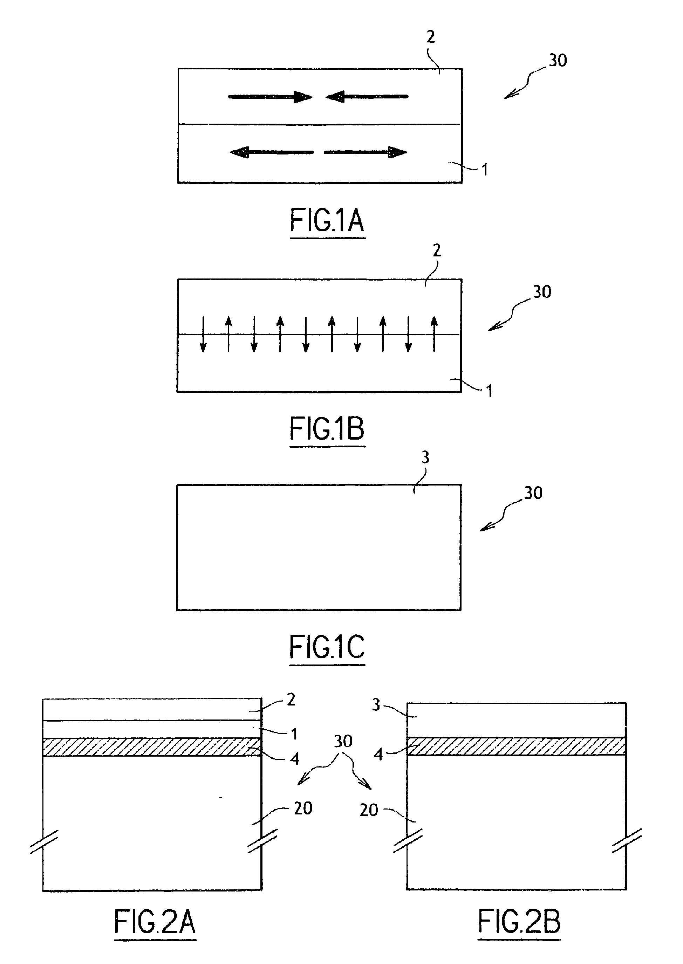

Le procédé selon l'invention comprend une étape de diffusion entre deux couches cristallines élastiquement contraintes pour former au final une unique couche cristalline de composition homogène élastiquement non contrainte.
Selon la figure 1A, la formation d'une telle couche non contrainte, est mise en oeuvre à partir d'une structure 30 comprenant une première couche cristalline élastiquement contrainte en tension 1 (la tension étant schématisée sur la figure par des flèches divergentes) et une deuxième couche cristalline élastiquement contrainte en compression 2 (la compression étant schématisée sur la figure par les flèches convergentes), la deuxième couche 2 étant adjacente à la première couche 1.

Selon une configuration alternative de l'invention, la première couche 1 peut être à l'inverse contrainte en compression et la deuxième couche 2 contrainte en tension, sans modifier pour autant l'étape de diffusion mise ensuite en oeuvre.

La structure 30 peut n'être formée que des deux couches 1 et 2, ou comprendre un support (tel qu'un raidisseur ou un substrat de croissance) du côté de l'une et/ou de l'autre des deux couches 1 et 2.

Selon une première configuration, la couche 2 présente les caractéristiques d'une couche qui a été épitaxiée sur la couche 1, cette dernière couche étant alors un substrat de croissance. Alternativement, la couche 1 peut présenter les caractéristiques d'une couche épitaxiée sur la couche 2, cette dernière couche jouant alors un rôle de substrat de croissance.

La croissance cristalline de la couche épitaxiée peut avoir été obtenue en utilisant les techniques connues LPD, CVD et MBE (abréviations respectives de « Low Power Deposition », « Chemical Vapor Deposition » et « Molecular Beam Epitaxy »).

Afin d'éviter l'apparition de défauts de type plastique dans la couche épitaxiée, tout en lui garantissant la contrainte élastique souhaitée, il est souhaitable que la couche ainsi épitaxiée ait une épaisseur inférieure à une épaisseur critique déterminée essentiellement en fonction des différences de paramètres de maille nominaux des matériaux respectifs composant les deux couches 1 et 2. On se référera aux ouvrages et connaissances connues pour déterminer cette épaisseur critique. Par exemple, on pourra se référer au document "High-mobility Si and Ge structures" de Friedrich Schaffler ("Semiconductor Science Technology" 12 (1997) 1515-1549) pour la détermination de l'épaisseur critique d'une couche 1 en $Si_{1-x}Ge_x$ et pour une couche 2 en $Si_{1-y}Ge_y$ (x étant différent de y).

Selon une deuxième configuration, les couches 1 et 2 ont été collées ensemble en employant des techniques de collage connues (voir par exemple « Semiconductor Wafer Bonding Science and Technology » de Q-Y. Tong et U. Gösele - a Wiley Interscience publication, Johnson Wiley & Sons, Inc. - pour plus de précisions). On pourra ainsi choisir par exemple un collage moléculaire de surfaces hydrophiles ou rendues hydrophiles, ou un collage après traitement plasma de l'une et/ou de l'autre des deux surfaces à coller, suivi d'un recuit classique ou d'un traitement RTA (acronyme anglo-saxon de « Rapid Thermal Annealing » ou « Recuit Thermique Rapide »).

Dans le cas où les deux couches 1 et 2 ont été collées l'une à l'autre, il est essentiel de choisir des techniques de collage non susceptibles d'entraver les phénomènes de la diffusion entre les deux couches 1-2 ensuite mise en oeuvre selon l'invention. En particulier, on prendra soin de préparer de manière connue les surfaces à coller pour les rendre non rugueuses et de les nettoyer efficacement de sorte qu'elles ne présentent plus de contaminants et de particules isolées pouvant perturber le phénomène de diffusion. Des traitements chimiques adaptés de nettoyage des surfaces à coller pourront être mis en oeuvre, tels que des faibles gravures chimiques, un traitement RCA, des bains ozonés, des rinçages, etc. Des traitements mécaniques ou mécano-chimiques peuvent aussi être mis en oeuvre, tels qu'un polissage, une abrasion, une CMP (abréviation anglo-saxonne de « Chemical Mechanical Planarization ») ou un bombardement d'espèces atomiques. En outre, on réalisera le collage sans couche de collage (de type $SiO_2$ ou $Si_3N_4$ par exemple) ou avec une couche de collage si fine qu'elle ne puisse substantiellement pas empêcher ou ralentir la diffusion entre les deux couches 1 et 2.

Les compositions, les épaisseurs et les taux de contraintes respectifs des deux couches 1 et 2 sont choisis de sorte que, après la mise en oeuvre de la diffusion, le matériau constituant alors la couche finale non contrainte à former ne présente globalement plus de contrainte élastique.

En particulier, les paramètres de maille des couches 1 et 2 contraintes sont avantageusement choisis respectivement égaux au paramètre de maille nominal du matériau constituant la couche finale que l'on souhaite former.

En particulier, les compositions et les épaisseurs respectives des couches 1 et 2 contraintes sont avantageusement choisies pour que, une fois que l'homogénéisation par diffusion des deux couches 1 et 2 en une couche finale sera réalisée, la couche finale ait la composition souhaitée.

En référence à la figure 1B, le procédé comprend une étape de diffusion entre les deux couches 1 et 2 de sorte que les différences entre leurs compositions respectives se réduisent progressivement.

Ce phénomène entraîne donc des déplacements entre les couches 1 et 2 d'éléments constitutifs de leurs matériaux, de sorte à diminuer progressivement leurs différences de compositions (les déplacements entre les couches 1 et 2 étant schématisés sur la figure par les flèches).

La diffusion est mise en oeuvre avantageusement par traitement thermique, adapté à une ou des température (s) déterminée(s) pendant respectivement une ou plusieurs durée(s) temporelle(s) afin d'obtenir le résultat escompté, c'est-à-dire une couche finale élastiquement non contrainte. On peut par exemple réaliser un traitement thermique à une température comprise entre 900°C et 1200°C pendant 30 min à quelques heures.

En référence à la figure 1C, est représentée le résultat obtenu après la mise en oeuvre de la diffusion : les compositions respectives des deux couches 1 et 2 sont sensiblement identiques l'une à l'autre, les deux couches 1 et 2 ne formant alors plus qu'une seule couche finale 3 en un matériau cristallin ayant une composition globalement uniforme et non contrainte élastiquement.

Selon une configuration particulière de l'invention, les matériaux constituant les couches 1 et 2 peuvent avoir initialement au moins un élément de leurs compositions respectives en commun. Ainsi, si une des deux couches 1 ou 2 a une composition telle qu'elle comprend plus de cet élément que l'autre couche, la diffusion de cet élément se fera davantage de cette première couche vers l'autre couche pour homogénéiser la composition de l'ensemble.

Par exemple, la première couche 1 est en $Si_{1-x}Ge_x$, la deuxième couche 2 est en $Si_{1-y}Ge_y$. Selon l'invention, on choisira leurs épaisseurs et leurs taux de contraintes (i.e. leurs paramètres de maille respectifs selon leurs compositions) pour obtenir une couche finale 3 en $Si_{1-z}Ge_z$ non contrainte (x et y étant respectivement compris entre 0 inclus et 1 inclus, x étant sensiblement différent de y) :

Ainsi, on choisira x, y, $th_1$ et $th_2$ de sorte que :

$$z = ( x * th_1 + y * th_2 ) / ( th_1 + th_2 ) \hspace{3cm} (1)$$

- $th_1$ étant l'épaisseur de la première couche 1
- $th_2$ étant l'épaisseur de la deuxième couche 2

Ainsi, les paramètres de maille respectifs des première et deuxième couches 1 et 2 contraintes sont respectivement égaux au paramètre de maille nominal du $Si_{1-z}Ge_z$.

Bien entendu, on pourra prendre soin que $th_1$ et $th_2$ soient respectivement inférieurs aux épaisseurs critiques des couches 1 et 2.

En référence à la figure 2A, une mise en oeuvre particulière de l'invention est le cas où la structure 30 est initialement une structure sSOI (acronyme anglo-saxon de « strained Silicon-On-Insulator » pour « Silicium contraint-Sur-Isolant ») comportant donc une première couche 1 en Si contraint et un substrat massif isolant selon une première configuration (non représentée), ou une première couche 1 en Si contraint, un substrat massif 20 et une couche isolante 4 intercalée selon une deuxième configuration (représentée).

Ce type de substrat sSOI 30 est disponible sur le marché.

Dans cet exemple, on fixe en premier lieu le taux de contrainte de la première couche 1 de Si en choisissant un substrat de sSOI 30 avec un taux de contrainte déterminé. On choisit ainsi le paramètre de maille de la couche finale 3 à former.

Selon une deuxième étape, on choisit la composition de la deuxième couche 2 à épitaxier ainsi que les épaisseurs respectives de la première couche 1 (qui peut encore être éventuellement modifiée) et de la deuxième couche 2 pour former une couche finale 3 ayant, après homogénéisation des deux couches 1-2 par diffusion, un paramètre de maille nominal égal à celui de la première couche 1.

Par exemple, si on choisit la composition de la deuxième couche 2 comme étant du $Si_{1-y}Ge_y$, une simple épitaxie de la deuxième couche 2 en $Si_{1-y}Ge_y$ sur le substrat sSOI 30, en choisissant selon l'invention son épaisseur selon l'épaisseur de la première couche 1 (voir relation (1) ci-dessus), suivie d'une simple étape de diffusion par traitement thermique selon l'invention, pourra permettre d'obtenir une couche finale 3 de $Si_{1-z}Ge_z$ non contrainte.

Le choix initial de la composition de $Si_{1-y}Ge_y$ peut aussi être guidé par des limites en terme d'épaisseur critique. En effet, si on choisit une concentration y en Ge supérieure à une concentration limite déterminée, l'épaisseur $th_2$ à choisir pour former finalement une couche 3 en $Sk_{1-z}Ge_z$ non contraint est supérieure à l'épaisseur critique. On obtient alors une deuxième couche 2 avec des relaxations plastiques de contrainte (dislocations, fautes d'empilement, et/ou autres défauts plastiques) et donc une couche finale 3 de mauvaise qualité cristalline.

Certaines conditions d'épitaxie, telles que celles décrites dans « Strain relaxation kinetics in Si1-xGex/Si heterostructures » de D. C. Houghton (J. Appl. Phys. 70 (4), 15 August 1991) permettent cependant de réaliser une croissance cristalline de couche au-delà de l'épaisseur critique théorique ; on pourra aussi se référer à « Defects in epitaxial multilayers » J. W. Matthews et al (Journal of Crystal Growth 27 (1974) 118-125), qui décrit les phénomènes physiques apparaissant au-delà de l'épaisseur critique, ainsi que l'influence des techniques de dépôt sur l'apparition de ces phénomènes.

A partir de la structure 30 ainsi formée, une diffusion selon l'invention est alors mise en oeuvre. Par exemple, on pourra choisir une température d'environ 1050°C pendant environ 2 heures.

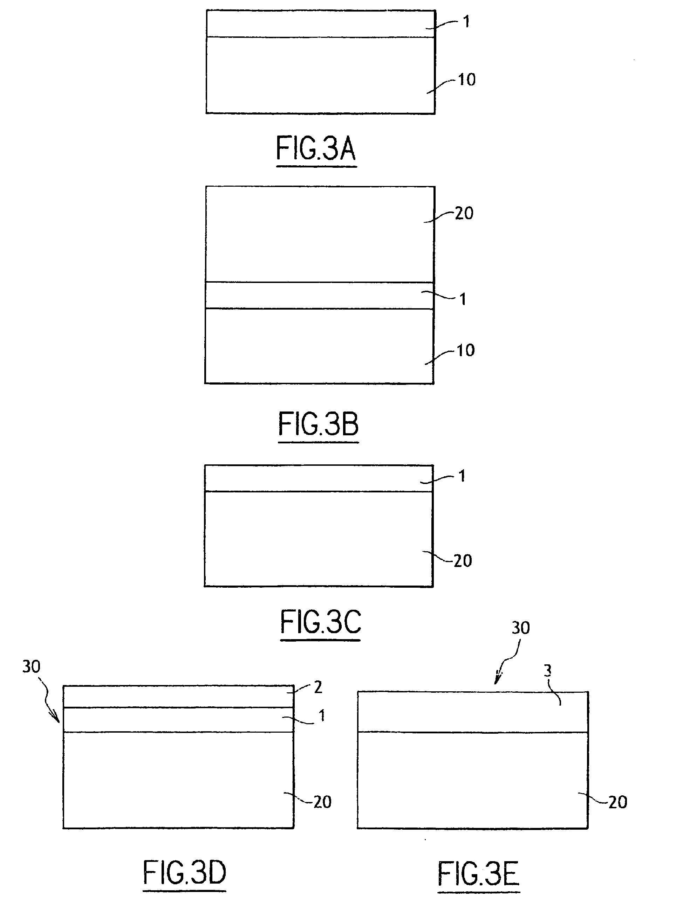

En référence à aux figures 3A à 3E sont présentées plusieurs étapes d'un autre procédé particulier selon l'invention, comprenant les étapes suivantes :

(1) épitaxie d'une première couche mince 1 en matériau cristallin contraint élastiquement sur un substrat donneur 10 ;

(2) collage d'un substrat récepteur 20 avec le substrat donneur 10 au niveau de la couche contrainte 1 ;

(3) retrait du substrat donneur 10 ;

(4) croissance cristalline d'une deuxième couche élastiquement contrainte 2 ;

(5) diffusion selon l'invention.

En référence à la figure 3A, est représentée une plaquette constituée d'un substrat donneur 10 et d'une première couche contrainte 1 en $Si_{1-x}Ge_x$ (x étant compris entre 0 inclus et 1 inclus).

Dans une configuration du substrat donneur 10, ce dernier est un pseudo-susbtrat comprenant une couche tampon (telle que définie précédemment) sur un substrat support (non représentés sur la figure 3A). La couche tampon en SiGe peut ainsi être par exemple formée par épitaxie à partir du substrat support en Si massif monocristallin et présenter globalement une augmentation de sa concentration en Ge dans son épaisseur, de sorte à modifier graduellement le paramètre de maille nominal du Si du substrat support en celui d'un SiGe. La couche tampon est agencée de sorte à comprendre en outre une couche supérieure en $Si_{1-w}Ge_w$ relaxée (w étant différent de x) présentant un paramètre de maille déterminé et ayant une épaisseur suffisamment importante pour pouvoir imposer son paramètre de maille à la première couche contrainte 1 sus-jacente, sans que cette dernière n'influence sensiblement sa propre structure cristalline.

Quelle que soit la configuration choisie pour le substrat donneur 10, ce dernier a une structure cristalline qui induise dans la couche contrainte 1 des contraintes élastiques et une densité faible de défauts plastiques.

Le Ge ayant un paramètre de maille supérieur d'environ 4,2 % au Si, le matériau choisi pour constituer cette première couche contrainte 1 est ainsi contraint en tension si x est inférieur à w, et est contrainte en compression si x est inférieur à w.

La première couche contrainte 1 est avantageusement formée sur le substrat donneur 10 par croissance cristalline, telle qu'une épitaxie en utilisant les techniques connues LPD, CVD et MBE.

Il est préférable de mettre en oeuvre le dépôt de la couche 1 pour qu'elle ait une épaisseur sensiblement constante, afin qu'elle présente des propriétés intrinsèques sensiblement constantes et/ou pour faciliter le futur collage avec le substrat récepteur 20 (tel que représenté sur la figure 3B).

Pour éviter une relaxation de la couche contrainte 1 ou une apparition de déformations internes de type plastique, il est préféré de garder l'épaisseur de cette dernière inférieure à une épaisseur critique de contrainte élastique.

En ce qui concerne des valeurs d'épaisseur critique pour des couches de $Si_{1-x}Ge_x$, on pourra notamment se référer au document intitulé « High-mobility Si and Ge structures » de Friedrich Schäffler (« Semiconductor Science Technology » 12 (1997) 1515-1549).

Pour les autres matériaux, l'homme du métier se référera à l'état de la technique pour connaître la valeur de l'épaisseur critique de contrainte élastique du matériau qu'il choisit pour la couche contrainte 1 formée sur le substrat donneur 10.

Ainsi, une couche de $Si_{1-x}Ge_x$ (x compris entre 0,10 et 0,30) épitaxiée sur du Si relaxé, a une épaisseur typique comprise entre environ 200 Å et 2000 Å, préférentiellement entre 200 Å et 500 Å en adaptant notamment les paramètres de croissance.

Une fois formée, la couche contrainte 1 a donc un paramètre de maille sensiblement voisin de celui de son substrat de croissance 10 et présente un paramètre de maille sensiblement égal au paramètre de maille de la couche non contrainte que l'on souhaite formée selon l'invention.

En référence à la figure 3B, un collage du substrat donneur 10 avec le substrat récepteur 20 est mis en oeuvre.

Avant collage, une étape optionnelle de formation d'une couche de collage sur au moins une des deux surfaces à coller peut être mise en oeuvre, cette couche de collage ayant des propriétés liantes, à température ambiante ou à des températures plus élevées.

Ainsi, par exemple, une formation d'une couche de $SiO_2$ ou de $Si_3N_4$ pourra améliorer la qualité du collage, notamment si l'autre surface à coller est en $SiO_2$ ou contient du Si.

Une couche de collage en $SiO_2$ est alors avantageusement réalisée par dépôt d'espèces atomiques de $SiO_2$ ou par oxydation thermique de la surface à coller si la surface de cette dernière contient du Si.

Une étape de préparation des surfaces à coller est, préalablement au collage, avantageusement mise en oeuvre afin de rendre ces surfaces les plus lisses et les plus propres possibles.

L'opération de collage en tant que telle s'effectue par une mise en contact des surfaces à coller. Les liaisons de collage sont préférentiellement de nature moléculaire en utilisant des propriétés hydrophiles des surfaces à coller. Les surfaces de collage peuvent aussi être traitées par plasma.

Un recuit de l'ensemble collé peut en outre être mis en oeuvre pour renforcer les liaisons de collage, par exemple en modifiant la nature des liaisons de collage, telles que des liaisons de covalence ou autres liaisons.

Ainsi, un recuit peut accentuer les liaisons de collage, notamment si une couche de collage a été formée préalablement au collage.

Pour plus de précisions quant aux techniques de collage, on pourra se référer notamment au document intitulé « Semiconductor Wafer Bonding » (Science and technology, Interscience Technology) par Q. Y. Tong, U. Gösele et Wiley.

En référence à la figure 3C, une fois l'ensemble collé, un enlèvement du substrat donneur 10 est mis en oeuvre.

La contrainte de la première couche 1 est alors conservée essentiellement grâce aux forces de collage (voir en particulier WO 04/006326, incorporé ici par référence, pour plus de précisions).

Selon une première mise en oeuvre, l'enlèvement de matière consiste à détacher au moins une partie du substrat donneur 10 au niveau d'une zone de fragilisation présente dans le substrat donneur 10, par apport d'énergie.

Cette zone de fragilisation (non représentée) est une zone sensiblement parallèle à la surface de collage, présentant des fragilités de liaisons à son niveau, ces liaisons fragiles étant susceptibles d'être rompues sous un apport d'une énergie adapté, telle qu'une énergie thermique et/ou mécanique.

La zone de fragilisation peut avoir été formée par implantation d'espèces atomiques dans le substrat donneur 10.

Les espèces implantées peuvent être de l'hydrogène, de l'hélium, un mélange de ces deux espèces ou d'autres espèces préférentiellement légères.

Cette implantation a été mise en oeuvre avant collage, avant ou après la formation de la couche contrainte 1.

La fragilité des liaisons dans la zone de fragilisation est trouvée principalement par le choix du dosage des espèces implantées. Dans le cas d'une implantation d'hydrogène, le dosage est ainsi typiquement compris entre $10^{16}$ cm$^{-2}$ et $10^{17}$ cm$^{-2}$, et plus précisément entre environ $2.10^{16}$ cm$^{-2}$ et environ $7.10^{16}$ cm$^{-2}$.

Le détachement au niveau de cette zone de fragilisation s'effectue alors habituellement par apport d'énergie mécanique et/ou thermique.

Pour plus de précisions quant à ce procédé dit Smart Cut®, on se référera notamment au document intitulé « Silicon-On-Insulator Technology : Materials to VLSI, 2nd Edition » de J.-P. Colinge édité chez « Kluwer Academic Publishers », p.50 et 51.

Après détachement au niveau de la zone de fragilisation, la partie éventuellement restante du substrat donneur 10 est enlevée pour ne garder que la couche contrainte 1 sur le substrat récepteur 20.

Des techniques de finition telles qu'un polissage, une abrasion, une planarisation CMP, un recuit thermique RTA, une oxydation sacrificielle, une gravure chimique, prises seules ou en combinaison peuvent alors être mises en oeuvre (renforcement de l'interface de collage, élimination de rugosités, guérison de défauts, etc.).

De manière avantageuse, l'enlèvement de matière de finition met en oeuvre au moins en fin d'étape une gravure chimique sélective, prise en combinaison ou non avec des moyens mécaniques.

Alternativement, une autre technique d'enlèvement de matière sans détachement et sans zone de fragilisation, peut être mise en oeuvre pour l'étape de retrait du substrat donneur 10.

Elle consiste à mettre en oeuvre une gravure chimique et/ou mécano-chimique.

On peut par exemple graver éventuellement sélectivement du ou des matériaux du substrat donneur 10 à retirer, selon un procédé de type « etch-back ».

Cette technique consiste à graver le substrat donneur 10 « par derrière », c'est-à-dire à partir de la face libre du substrat donneur 10.

Des gravures par voie humide mettant en oeuvre des solutions de gravure adaptées aux matériaux à enlever peuvent être mises en oeuvre.

Des gravures par voie sèche peuvent également être mises en oeuvre pour enlever de la matière, telles que des gravures par plasma ou par pulvérisation.

La ou les gravures peuvent être précédées ou suivies par une attaque mécanique du substrat donneur 10, tel un meulage, un polissage, une gravure mécanique ou une pulvérisation d'espèces atomiques.

La ou les gravures peuvent être accompagnées d'une attaque mécanique, tel qu'un polissage éventuellement combiné avec une action d'abrasifs mécaniques dans un procédé CMP.

Toutes les techniques précitées d'enlèvement de matière du substrat donneur 10, sont proposées à titre d'exemple dans le présent document, mais ne constituent en rien une limitation, l'invention s'étendant à tous types de techniques aptes à enlever le substrat donneur 10, conformément au procédé selon l'invention.

En référence à la figure 3D, une épitaxie selon l'invention d'une deuxième couche contrainte 2 en Si$_{1-y}$Ge$_y$ est mise en oeuvre, telle que précédemment décrite.

Si la première couche 1 est contrainte en tension (i.e. si *x* est inférieur à *w*), la deuxième couche 2 est choisie pour être contrainte en compression (i.e. *y* est supérieur à *w*).

Inversement, si la première couche 1 est contrainte en compression (i.e. si *x* est supérieur à *w*), la deuxième couche 2 est choisie pour être contrainte en tension (i.e. *y* est inférieur à *w*).

Le choix des compositions, des épaisseurs, et des paramètres de maille est déterminé conformément à ce qui a déjà été expliqué auparavant.

Alternativement, la deuxième couche 2 peut être épitaxiée sur la première couche 1 avant le collage, le collage étant alors réalisé au niveau de la surface de la couche 2. On obtient ainsi une structure 30 ayant successivement le substrat récepteur 20, la couche 2 puis la couche 1 (à l'inverse de la figure 3D).

En référence à la figure 3E, un traitement thermique de diffusion selon l'invention est mise en oeuvre, afin de former une structure 30 ayant une couche finale 3 en $Si_{1-z}Ge_z$. Cette structure est une structure SiGeOI dans le cas où le substrat récepteur 20 est un isolant électrique ou qu'une couche de collage suffisamment épaisse est comprise entre la couche 3 de $Si_{1-z}Ge_z$ et le substrat récepteur 20.

La structure finale 30 achevée, on peut éventuellement mettre en oeuvre des traitements de finition, comprenant par exemple un recuit.

Des composants électroniques, optiques et optroniques peuvent être réalisés alors dans la couche finale 3.

Une ou plusieurs épitaxies quelconque(s) peu(ven)t aussi être mise(s) en oeuvre sur la structure finale 30 (en référence à la figure 1C, 2B ou 3E), telle qu'une épitaxie d'une couche de SiGe ou de SiGeC, ou une épitaxie d'une couche de Si ou de SiC contraint, ou des épitaxies successives de couches SiGe ou de SiGeC et de couches de Si ou de SiC contraint en alternance pour former une structure multicouches.

La présente invention ne se limite pas à des couches contraintes 1 et 2 en Si ou en SiGe, mais s'étend aussi à d'autres types de matériaux, tels que des alliages de type III-V ou II-VI, ou à d'autres matériaux cristallins.

Dans les couches cristallines discutées ici, d'autres constituants peuvent y être ajoutés, tels que des éléments de dopage ou du carbone avec une concentration de carbone dans la couche considérée sensiblement inférieure ou égale à 50 % ou, plus particulièrement avec une concentration inférieure ou égale à 5 %.

## Revendications

1. Procédé de formation d'une couche en matériau cristallin non contraint élastiquement et destinée à des applications dans l'électronique, l'optique, ou l'optronique, **caractérisé en ce que** le procédé est mis en oeuvre à partir d'une structure comprenant une première couche cristalline élastiquement contrainte en tension (ou respectivement en compression) et une deuxième couche cristalline élastiquement contrainte en compression (ou respectivement en tension), la deuxième couche étant adjacente à la première couche, **en ce que** le procédé comprend une étape de diffusion entre les deux couches de sorte que les différences entre les compositions respectives des deux couches se réduisent progressivement, jusqu'à être identiques l'une à l'autre, les deux couches ne formant alors plus qu'une seule couche finale en un matériau cristallin ayant une composition globalement uniforme, **en ce que** les compositions, les épaisseurs et les taux de contraintes respectifs des deux couches sont initialement choisis de sorte que, après diffusion, le matériau constituant alors la couche finale ne présente globalement plus de contrainte élastique et **en ce que** le paramètre de maille de la première couche est choisi sensiblement égal au paramètre de maille nominal du matériau composant la couche finale.

2. Procédé de formation d'une couche en matériau cristallin non contraint élastiquement selon la revendication précédente, dans lequel les paramètres de maille des première et deuxième couches contraintes sont respectivement égaux au paramètre de maille nominal du matériau constituant la couche finale.

3. Procédé de formation d'une couche en matériau cristallin non contraint élastiquement selon l'une des revendications précédentes, dans lequel la deuxième couche est une couche épitaxiée sur la première couche.

4. Procédé de formation d'une couche en matériau cristallin non contraint élastiquement selon l'une des revendications précédentes, dans lequel les première et deuxième couches ont au moins un élément de leurs compositions respectives en commun.

5. Procédé de formation d'une couche en matériau cristallin non contraint élastiquement selon la revendication précédente, dans lequel la première couche est en Si1-xGex, la deuxième couche est en Si1-yGey et la couche finale est en Si1-zGez, x et y étant respectivement compris entre 0 inclus et 1 inclus, x étant sensiblement différent de y, et :

$$z = ( x * th_1 + y * th_2 ) / ( th_1 + th_2 )$$

$th_1$ étant l'épaisseur de la première couche ;
$th_2$ étant l'épaisseur de la deuxième couche ;
et dans lequel les paramètres de maille respectifs des première et deuxième couches contraintes sont respectivement égaux au paramètre de maille nominal du $Si_{1-z}Ge_z$.

6. Procédé de formation d'une couche en matériau cristallin non contraint élastiquement selon l'une des revendications précédentes, dans lequel ladite structure comprend en outre une couche en matériau amorphe située sous les deux couches cristallines.

**7.** Procédé de formation d'une couche en matériau cristallin non contraint élastiquement selon la revendication précédente, dans lequel la couche en matériau amorphe est électriquement isolante.

**8.** Procédé de formation d'une couche en matériau cristallin non contraint élastiquement selon la revendication précédente, dans lequel la couche en matériau amorphe comprend au moins un des matériaux suivants : SiO2, Si3N4, SixOyNz.

**9.** Procédé de formation d'une couche en matériau cristallin non contraint élastiquement selon l'une des revendications précédentes, dans lequel la diffusion est mise en oeuvre par traitement thermique.

**10.** Procédé de réalisation d'une structure comprenant une couche cristalline non contrainte élastiquement et destinée à des applications dans l'électronique, l'optique, ou l'optronique, **caractérisé en ce qu'**il comprend les étapes suivantes :

- croissance cristalline d'une deuxième couche cristalline sur une première couche cristalline élastiquement contrainte en tension (ou respectivement en compression), de sorte que la deuxième couche soit élastiquement contrainte en compression (ou respectivement en tension) par la première couche, et que l'épaisseur de la deuxième couche soit choisie de l'ordre d'une épaisseur de référence, l'épaisseur de référence correspondant à une épaisseur pour laquelle l'ensemble des éléments composant la deuxième couche et l'ensemble des éléments composant la première couche puissent former, une fois combinés ensemble, une couche uniforme globalement non contrainte, le paramètre de maille de la première couche étant choisi sensiblement égal au paramètre de maille nominal du matériau composant la couche finale;
- diffusion d'éléments entre les deux couches de sorte que les différences entre les compositions respectives des deux couches se réduisent progressivement, jusqu'à être identiques l'une à l'autre, les deux couches ne formant alors plus qu'une seule couche finale en un matériau cristallin ayant une composition globalement uniforme et élastiquement non contrainte, réalisant au moins une partie de ladite structure.

**11.** Procédé de réalisation d'une structure selon la revendication 10, dans lequel la croissance cristalline est en outre mise en oeuvre de sorte que la deuxième couche ait une épaisseur inférieure ou égale à une épaisseur critique au-delà de laquelle des contraintes élastiques se relâcheraient substantiellement.

**12.** Procédé de réalisation d'une structure selon la revendication 10 ou 11, comprenant en outre, antérieurement à l'étape de croissance cristalline, un collage de la première couche avec un substrat récepteur, ladite structure finalement réalisée comprenant donc ladite couche finale mais aussi ce substrat récepteur.

**13.** Procédé de réalisation d'une structure selon la revendication précédente, dans lequel le collage est réalisé par l'intermédiaire d'une couche de collage formée sur l'une et/ou l'autre des faces à coller.

**14.** Procédé de réalisation d'une structure selon la revendication précédente, dans lequel la couche de collage comprend au moins un des deux matériaux suivants : $SiO_2$, $Si_3N_4$.

**15.** Procédé de réalisation d'une structure selon l'une des revendications 13 et 14, dans lequel le collage est moléculaire et est ensuite renforcé par un traitement thermique adapté.

**16.** Procédé de réalisation d'une structure selon l'une des revendications 13 à 15 , dans lequel la première couche est comprise dans une plaque au moment du collage, et dans lequel le procédé comprend en outre, entre les étapes de collage et de croissance cristalline, un retrait de la partie de la plaque ne comprenant pas la première couche.

**17.** Procédé de réalisation d'une structure selon la revendication précédente, dans lequel le retrait de la partie de la plaque ne comprenant pas la première couche est mis en oeuvre par au moins une des techniques suivantes : meulage, CMP, CMP sélective, gravure chimique, gravure chimique sélective.

**18.** Procédé de réalisation d'une structure selon la revendication 16, comprenant en outre, antérieurement au collage, une implantation d'espèces atomiques dans la plaque de sorte à y créer une zone de fragilisation à une profondeur sensiblement égale à l'épaisseur de la première couche ; et dans lequel le retrait d'une partie de la plaque est obtenu en soumettant la zone de fragilisation à des contraintes aptes à rompre les liaisons fragiles et à détacher alors ladite première couche du reste de la plaque.

19. Procédé de réalisation d'une structure selon l'une des revendications 16 à 18, comprenant en outre, entre le retrait d'une partie de la plaque et la croissance cristalline, une étape de finition de la surface de la première couche pour préparer sa surface à la croissance cristalline de la deuxième couche.

20. Procédé de réalisation d'une structure selon l'une des revendications 10 à 19, dans lequel la première couche est en Si1-xGex, la deuxième couche est en Si1-yGey, et la couche finale est en Si1-zGez, x et y étant respectivement compris entre 0 inclus et 1 inclus, x étant sensiblement différent de y, et :

$$z = ( x * th_1 + y * th_2 ) / ( th_1 + th_2 )$$

$th_1$ étant l'épaisseur de la première couche ;
$th_2$ étant l'épaisseur de la deuxième couche ;
et dans lequel le paramètre de maille de la première couche contrainte est sensiblement égal au paramètre de maille nominal du $Si_{1-z}Ge_z$.

21. Procédé de réalisation d'une structure selon l'une des revendications 10 à 20, dans lequel la première couche est en Si contraint et est comprise dans un substrat silicium contraint-sur-isolant (« sSOI »).

## Claims

1. A method of forming a layer of elastically unstrained crystalline material intended for electronics, optics, or optronics applications, **characterized in that** the method is implemented from a structure comprising a first crystalline layer which is elastically strained in tension (or respectively in compression) and a second crystalline layer which is elastically strained in compression (or respectively in tension), the second layer being adjacent to the first layer, **in that** the method comprises a step of diffusion between the two layers so that the differences between the respective compositions of the two layers reduce progressively until they are the same, the two layers then forming just a single final layer of crystalline material having, in aggregate, a uniform composition, **in that** the respective compositions, thicknesses, and degrees of strain of the two layers are initially selected so that, after diffusion, the material then constituting the final layer no longer, in aggregate, exhibits elastic strain, and **in that** the lattice parameter of the first layer is selected so as to be substantially equal to the nominal lattice parameter of the material composing the final layer.

2. A method of forming a layer of elastically unstrained crystalline material according to the preceding claim, in which the lattice parameters of the first and second strained layers are respectively equal to the nominal lattice parameter of the material constituting the final layer.

3. A method of forming a layer of elastically unstrained crystalline material according to either of the preceding claims, in which the second layer is a layer which is epitaxially grown on the first layer.

4. A method of forming a layer of elastically unstrained crystalline material according to any preceding claim, in which the first and second layers have at least one element in their respective compositions in common.

5. A method of forming a layer of elastically unstrained crystalline material according to the preceding claim, in which the first layer is formed from $Si_{1-x}Ge_x$, the second layer is formed from $Si_{1-y}Ge_y$ and the final layer is formed from $Si_{1-z}Ge_z$, x and y respectively being in the range 0 (inclusive) to 1 (inclusive), x being substantially different from y, and:

$$z = (x*th_1 + y*th_2)/(th_1 + th_2)$$

$th_1$ being the thickness of the first layer;
$th_2$ being the thickness of the second layer;

and in which the respective lattice parameters of the first and second strained layers are respectively equal to the nominal lattice parameter of $Si_{1-z}Ge_z$.

6. A method of forming a layer of elastically unstrained crystalline material according to any preceding claim, in which said structure further comprises a layer of amorphous material located beneath the two crystalline layers.

7. A method of forming a layer of elastically unstrained crystalline material according to the preceding claim, in which the layer of amorphous material is electrically insulating.

8. A method of forming a layer of elastically unstrained crystalline material according to the preceding claim, in which the layer of amorphous material comprises at least one of the following materials: $SiO_2$, $Si_3N_4$, $Si_xO_yN_z$.

9. A method of forming a layer of elastically unstrained crystalline material according to any preceding claim, in which the diffusion is carried out by heat treatment.

10. A method of producing a structure comprising an elastically unstrained crystalline layer intended for electronics, optics, or optronics applications, **characterized in that** it comprises the following steps:

   - crystal growth of a second crystalline layer on a first crystalline layer which is elastically strained in tension (or respectively in compression), so that the second layer is elastically strained in compression (or respectively in tension) by the first layer, and so that the thickness of the second layer is selected to be of the order of a reference thickness, the reference thickness corresponding to a thickness for which the assembly of elements composing the second layer and the assembly of elements composing the first layer, once combined together, can form a uniform layer which, in aggregate, is unstrained, the lattice parameter of the first layer being selected so as to be substantially equal to the nominal lattice parameter of the material composing the final layer;
   - diffusion of elements between the two layers so that the differences between the respective compositions of the two layers are progressively reduced until they are the same, the two layers then forming just a single final layer of a crystalline material having a composition which, in aggregate, is uniform and elastically unstrained, producing at least part of said structure.

11. A method of producing a structure according to claim 10, in which the crystal growth is also carried out so that the thickness of the second layer is less than or equal to a critical thickness beyond which elastic strains would substantially relax.

12. A method of producing a structure according to claim 10 or 11, further comprising, before the crystal growth step, bonding the first layer with a receiver substrate, said structure which is finally formed thus comprising said final layer and also said receiver substrate.

13. A method of producing a structure according to the preceding claim, in which bonding is carried out via a bonding layer formed on one and/or the other of the faces to be bonded.

14. A method of producing a structure according to the preceding claim, in which the bonding layer comprises at least one of the following two materials: $SiO_2$, $Si_3N_4$.

15. A method of producing a structure according to either of claims 13 and 14, in which the bonding is direct wafer bonding and is then reinforced by a suitable heat treatment.

16. A method of producing a structure according to any one of claims 13 to 15, in which the first layer is comprised in a wafer at the time of bonding, and in which the method further comprises, between the bonding and crystal growth steps, lifting off the portion of the wafer which does not comprise the first layer.

17. A method of producing a structure according to the preceding claim, in which the portion of the wafer which does not comprise the first layer is lifted off by means of at least one of the following techniques: grinding, CMP, selective CMP, chemical etching, selective chemical etching.

18. A method of producing a structure according to claim 16, further comprising, prior to bonding, implanting atomic species into the wafer to create therein a zone of weakness at a depth which is substantially equal to the thickness of the first layer; and in which a portion of the wafer is lifted off by subjecting the zone of weakness to stresses which are capable of rupturing the weak bonds and thereby detaching said first layer from the remainder of the wafer.

19. A method of producing a structure according to any one of claims 16 to 18, further comprising, between lifting off part of the wafer and crystal growth, a step of finishing the surface of the first layer to prepare its surface for crystal growth of the second layer.

20. A method of producing a structure according to any one of claims 10 to 19, in which the first layer is formed from $Si_{1-x}Ge_x$, the second layer is formed from $Si_{1-y}Ge_y$ and the final layer is formed from $Si_{1-z}Ge_z$, x and y respectively being in the range 0 (inclusive) to 1 (inclusive), x being substantially different from y, and:

$$z = (x*th_1 + y*th_2)/(th_1 + th_2)$$

$th_1$ being the thickness of the first layer;
$th_2$ being the thickness of the second layer;
and in which the lattice parameter of the first strained layer is substantially equal to the nominal lattice parameter of $Si_{1-z}Ge_z$.

21. A method of producing a structure according to any one of claims 10 to 20, in which the first layer is formed from strained Si and is comprised in a strained silicon-on-insulator substrate (sSOI).

**Patentansprüche**

1. Verfahren zum Bilden einer Schicht aus kristallinem Material, das elastisch unverspannt ist und für Anwendungen in der Elektronik, Optik oder Optoelektronik vorgesehen ist, **dadurch gekennzeichnet, dass** das Verfahren ausgehend von einer Struktur umgesetzt wird, die eine erste kristalline Schicht umfasst, die durch Zug (bzw. durch Druck) elastisch verspannt ist, und eine zweite kristalline Schicht umfasst, die durch Druck (bzw. durch Zug) elastisch verspannt ist, wobei die zweite Schicht benachbart zur ersten Schicht ist, dadurch, dass das Verfahren eine Phase der Diffusion zwischen den beiden Schichten umfasst, derart, dass die Unterschiede zwischen den jeweiligen Zusammensetzungen der beiden Schichten sich fortschreitend verringern, bis sie einander gleich sind, wobei die beiden Schichten dann nur noch eine einzige resultierende Schicht aus einem kristallinem Material bilden, das eine im Ganzen gleichförmige Zusammensetzung hat, dadurch, dass die jeweiligen Zusammensetzungen, Dicken und Größen der Verspannungen der beiden Schichten anfänglich so gewählt sind, dass nach der Diffusion das Material, das dann die resultierende Schicht bildet, im Ganzen keine elastische Verspannung mehr aufweist, und dadurch, dass die Gitterkonstante der ersten Schicht im Wesentlichen gleich der vorgesehenen Gitterkonstante des Materials gewählt ist, das die resultierende Schicht bildet.

2. Verfahren zum Bilden einer Schicht aus elastisch unverspanntem kristallinem Material nach dem vorhergehenden Anspruch, bei dem die Gitterkonstanten der ersten und zweiten verspannten Schicht jeweils gleich der vorgesehenen Gitterkonstante des Materials sind, das die resultierende Schicht bildet.

3. Verfahren zum Bilden einer Schicht aus elastisch unverspanntem kristallinem Material nach einem der vorhergehenden Ansprüche, bei dem die zweite Schicht eine Schicht ist, die auf der ersten Schicht epitaktisch aufgewachsen ist.

4. Verfahren zum Bilden einer Schicht aus elastisch unverspanntem kristallinem Material nach einem der vorhergehenden Ansprüche, bei dem die erste und zweite Schicht wenigstens ein Element ihrer jeweiligen Zusammensetzung gemeinsam haben.

5. Verfahren zum Bilden einer Schicht aus elastisch unverspanntem kristallinem Material nach dem vorhergehenden Anspruch, bei dem die erste Schicht aus Si1-xGex, die zweite Schicht aus Si1-yGey und die resultierende Schicht aus Si1-zGez besteht, wobei x und y jeweils zwischen einschließlich 0 und einschließlich 1 liegen, x deutlich verschieden von y ist, und:

$$z = (x * th_1 + y * th_2) / (th_1 + th_2)$$

wobei $th_1$ die Dicke der ersten Schicht ist;
$th_2$ die Dicke der zweiten Schicht ist;
und bei dem die jeweiligen Gitterparameter der verspannten ersten und zweiten Schicht jeweils gleich dem vorgesehenen Gitterparameter des $Si_{1-z}Ge_z$ sind.

6. Verfahren zum Bilden einer Schicht aus elastisch unverspanntem kristallinem Material nach einem der vorhergehenden Ansprüche, bei dem die Struktur außerdem eine Schicht aus einem amorphen Material umfasst, die sich unter den beiden kristallinen Schichten befindet.

7. Verfahren zum Bilden einer Schicht aus elastisch unverspanntem kristallinem Material nach dem vorhergehenden Anspruch, bei dem die Schicht aus amorphem Material elektrisch isolierend ist.

8. Verfahren zum Bilden einer Schicht aus elastisch unverspanntem kristallinem Material nach dem vorhergehenden Anspruch, bei dem die Schicht aus amorphem Material wenigstens eines der folgenden Materialien umfasst: SiO2, Si3N4, SixOyNz.

9. Verfahren zum Bilden einer Schicht aus elastisch unverspanntem kristallinem Material nach einem der vorhergehenden Ansprüche, bei dem die Diffusion durch eine Wärmebehandlung ausgeführt wird.

10. Verfahren zum Herstellen einer Struktur, die eine elastisch unverspannte kristalline Schicht umfasst und die für Anwendungen in der Elektronik, Optik oder Optoelektronik vorgesehen ist, **dadurch gekennzeichnet, dass** es die folgenden Phasen umfasst:

- kristallines Aufwachsen einer zweiten kristallinen Schicht auf einer ersten kristallinen Schicht, die durch Zug (bzw. durch Druck) elastisch verspannt ist, derart, dass die zweite Schicht durch die erste Schicht durch Druck (bzw. durch Zug) elastisch verspannt ist, und dass die Dicke der zweiten Schicht in etwa gleich einer Bezugsdicke gewählt wird, wobei die Bezugsdicke einer Dicke entspricht, für die die Gesamtheit der Elemente, die die zweite Schicht bilden, und die Gesamtheit der Elemente, die die erste Schicht bilden, nachdem sie miteinander kombiniert sind, eine gleichförmige im Ganzen unverspannte Schicht bilden können, wobei die Gitterkonstante der ersten Schicht im Wesentlichen gleich der vorgesehenen Gitterkonstante des Materials gewählt ist, das die resultierende Schicht bildet;
- Diffusion von Elementen zwischen den beiden Schichten, derart, dass die Unterschiede zwischen den jeweiligen Zusammensetzungen der beiden Schichten sich fortschreitend verringern, bis sie einander gleich sind, wobei die beiden Schichten dann nur noch eine einzige resultierende Schicht aus einem kristallinem Material bilden, das eine im Ganzen gleichförmige Zusammensetzung hat und das elastisch unverspannt ist, wobei diese wenigstens einen Teil der Struktur bildet.

11. Verfahren zum Herstellen einer Struktur nach Anspruch 10, bei dem das kristalline Aufwachsen außerdem so ausgeführt wird, dass die zweite Schicht eine Dicke hat, die kleiner oder gleich einer kritischen Dicke ist, oberhalb derer elastische Verspannungen sich wesentlich entspannen würden.

12. Verfahren zum Herstellen einer Struktur nach Anspruch 10 oder 11, das außerdem vor der Phase des kristallinen Aufwachsens eine Verklebung der ersten Schicht mit einem Empfängersubstrat umfasst, wobei die abschließend realisierte Struktur somit die resultierende Schicht, jedoch auch dieses Empfängersubstrat umfasst.

13. Verfahren zum Herstellen einer Struktur nach dem vorhergehenden Anspruch, bei dem das Verkleben mittels einer Verklebungsschicht realisiert wird, die auf der einen und/oder der anderen der zu verklebenden Flächen gebildet wird.

14. Verfahren zum Herstellen einer Struktur nach dem vorhergehenden Anspruch, bei dem die Verklebungsschicht wenigstens eines der beiden folgenden Materialien umfasst: $SiO_2$, $Si_3N_4$.

15. Verfahren zum Herstellen einer Struktur nach einem der Ansprüche 13 und 14, bei dem die Verklebung molekular ist und anschließend durch eine angepasste Wärmebehandlung verstärkt wird.

**16.** Verfahren zum Herstellen einer Struktur nach einem der Ansprüche 13 bis 15, bei dem die erste Schicht im Moment der Verklebung in einer Platte enthalten ist und bei dem das Verfahren außerdem zwischen den Phasen der Verklebung und des kristallinen Aufwachsens ein Entfernen des Teils der Platte umfasst, der nicht die erste Schicht umfasst.

**17.** Verfahren zum Herstellen einer Struktur nach dem vorhergehenden Anspruch, bei dem das Entfernen des Teils der Platte, der nicht die erste Schicht umfasst, durch wenigstens eine der folgenden Techniken ausgeführt wird: Schleifen, CMP, selektives CMP, chemisches Ätzen, selektives chemisches Ätzen.

**18.** Verfahren zum Herstellen einer Struktur nach Anspruch 16, das außerdem vor dem Verkleben eine Implantation von Atomsorten in der Platte umfasst, und dies derart, dass dort eine Schwächungszone in einer Tiefe erzeugt wird, die im Wesentlichen gleich der Dicke der ersten Schicht ist; und bei dem das Entfernen eines Teils der Platte erreicht wird, indem die Schwächungszone Einwirkungen ausgesetzt wird, die dafür geeignet sind, die brüchigen Verbindungen aufzubrechen und dann die erste Schicht vom Rest der Platte zu lösen.

**19.** Verfahren zum Herstellen einer Struktur nach einem der Ansprüche 16 bis 18, das außerdem zwischen dem Entfernen eines Teils der Platte und dem kristallinen Aufwachsen eine Phase der Endbearbeitung der Oberfläche der ersten Schicht umfasst, um deren Oberfläche für das kristalline Aufwachsen der zweiten Schicht vorzubereiten.

**20.** Verfahren zum Herstellen einer Struktur nach einem der Ansprüche 10 bis 19, bei dem die erste Schicht aus Si1-xGex, die zweite Schicht aus Si1-yGey und die resultierende Schicht aus Si1-zGez besteht, wobei x und y jeweils zwischen einschließlich 0 und einschließlich 1 liegen, x deutlich verschieden von y ist, und:

$$z = (x * th_1 + y * th_2) / (th_1 + th_2)$$

wobei $th_1$ die Dicke der ersten Schicht ist;
$th_2$ die Dicke der zweiten Schicht ist;
und bei dem der Gitterparameter der verspannten ersten Schicht im Wesentlichen gleich dem vorgesehenen Gitterparameter des $Si_{1-z}Ge_z$ ist.

**21.** Verfahren zum Herstellen einer Struktur nach einem der Ansprüche 10 bis 20, bei dem die erste Schicht aus verspanntem Si besteht und in einem Substrat vom Typ "strained (verspanntes) Silicon on Insulator" ("sSOI") enthalten ist.

FIG.1A

FIG.1B

FIG.1C

FIG.2A

FIG.2B

FIG.3A

FIG.3B

FIG.3C

FIG.3D

FIG.3E

## RÉFÉRENCES CITÉES DANS LA DESCRIPTION

### Documents brevets cités dans la description

- WO 0199169 A
- US 2003013900 A
- WO 0227783 A

- WO 0215244 A
- WO 0406327 A
- WO 04006326 A

### Littérature non-brevet citée dans la description

- **JEAN-PIERRE COLINGE.** Silicon-on-insulator technology: materials to VLSI. Kluwer Academic Publishers, 50, 51
- **FRIEDRICH SCHAFFLER.** High-mobility Si and Ge structures. *Semiconductor Science Technology,* 1997, vol. 12, 1515-1549
- **Q-Y. TONG ; U. GÖSELE.** Semiconductor Wafer Bonding Science and Technology. Johnson Wiley & Sons, Inc,
- **D. C. HOUGHTON.** Strain relaxation kinetics in Si1-xGex/Si heterostructures. *J. Appl. Phys.,* 15 Août 1991, vol. 70 (4

- **J. W. MATTHEWS et al.** Defects in epitaxial multi-layers. *Journal of Crystal Growth,* 1974, vol. 27, 118-125
- **FRIEDRICH SCHÄFFLER.** High-mobility Si and Ge structures. *Semiconductor Science Technology,* 1997, vol. 12, 1515-1549
- Semiconductor Wafer Bonding. Interscience Technology
- **J.-P. COLINGE.** Silicon-On-Insulator Technology : Materials to VLSI. Kluwer Academic Publishers, 50, 51